# EUROPEAN PATENT SPECIFICATION

(11) **EP 3 762 980 B1**
(45) Date of publication and mention of the grant of the patent: **09.08.2023**
(21) Application number: 19710360.9
(22) Date of filing: 06.03.2019
(51) Int. Cl.: H10K 85/10, H10K 85/20, H10K 10/40, H10K 10/80

(54) **ORGANIC FIELD EFFECT TRANSISTOR COMPRISING SEMICONDUCTING SINGLE-WALLED CARBON NANOTUBES AND ORGANIC SEMICONDUCTING MATERIAL**
ORGANISCHER FELDEFFEKTTRANSISTOR MIT HALBLEITENDEN EINWANDIGEN KOHLENSTOFFNANORÖHRCHEN UND ORGANISCHEM HALBLEITENDEM MATERIAL
TRANSISTOR À EFFET DE CHAMP ORGANIQUE COMPRENANT DES NANOTUBES DE CARBONE À PAROI SIMPLE SEMI-CONDUCTEURS ET MATÉRIAU SEMI-CONDUCTEUR ORGANIQUE

(30) Priority: 08.03.2018 EP 18160612
(43) Date of publication of application: 13.01.2021
(73) Proprietor: CLAP CO., LTD., Gangnam-Gu Seoul 06109 (KR)
(72) Inventor: KWON, JungGou, Suwon-si, Gyeonggi-do 16342 (KR); LIM, SooMan, Jeollabuk-do 54896 (KR); BECKER, Stefan, 67056 Ludwigshafen (DE); LEE, JunMin, Suwon-si, Gyeonggi-do 16342 (KR); HSIAO, HsiangChih, Suwon-si, Gyeonggi-do 16342 (KR)
(74) Representative: Maiwald GmbH
(86) International application number: PCT/EP2019/055522
(87) International publication number: WO 2019/170719

(56) References cited:
- US-A1- 2012 187 379
- US-A1- 2017 141 319
- US-A1- 2018 026 214
- SMITHSON CHAD ET AL: "Using unsorted single-wall carbon nanotubes to enhance mobility of diketopyrrolopyrrole-quarterthiophene copolymer in thin-film transistors", ORGANIC ELECTRONICS, vol. 15, no. 11, 5 August 2014 (2014-08-05), pages 2639-2646, XP029076461, ISSN: 1566-1199, DOI: 10.1016/J.ORGEL.2014.07.021

## Description

The present invention relates to an organic field effect transistor comprising a double layer consisting of a first layer consisting of a percolating network of single-walled carbon nanotubes and a second layer comprising an organic semiconducting material as defined in claim 1, and to a process for the preparation of such a transistor. In recent years, the use of single-walled carbon nanotubes (SWCNT) in organic field effect transistors (OFETs) has attracted considerable interest.

In the beginning, the single-walled carbon nanotubes (SWCNT) were used as mixture of metallic and semiconducting single-walled carbon nanotubes in electronic devices as growth methods at that time yielded mixtures of metallic and semiconducting single-walled carbon nanotubes. Since methods for enriching the semiconducting single-walled carbon nanotubes in single-walled carbon nanotubes are available, also single-walled carbon nanotubes enriched in semiconducting single-walled carbon nanotubes are used in electronic devices.

The following publications describe preparation methods for organic field effect transistors using single-walled carbon nanotubes.

X.-Z. Bo, C.Y. Lee, M.S. Strano, M. Goldfinger, C. Nuckolis and G.B. Blanchet, Applied Physical Letters 2005, 86, 182102 disclose a bottom-gate, top-contact (BGTC) organic field effect transistor having a composite layer of individual single-walled carbon nanotubes (SWCNT), with a ratio of metallic : semiconducting SWCNT of 1 : 2, and poly(3-hexyl-thiophene) (P3HT) as semiconducting layer. The composite layer is prepared by mixing a dispersion of SWCNT with a solution of polythiophene and spincoting this composite mixture on the substrate.

Shuhong Liu, Alejandro L. Briseno, Stefan CB. Mannsfeld, Wie You, Jason Locklin, Hang Woo Lee, Youman Xia and Zhenan Bao, Advanced Functional Materials 2007, 17, 2891-2896 describe organic field effect transistors comprising single crystal organic semiconductor, prepared by growing crystals of the organic semiconductor onto patterned SWCNT bundles. The patterned SWCNT are obtained by printing using a stamp. The printed SWCNT bundles do not form connected paths between source-drain electrodes.

Shuhang Liu, Stefan C.B. Mannsfeld, Melbs C. Le Mieux, Hang W. Lee and Zhenon Bao, Applied Physical Letters 2008, 92, 053306 disclose bottom-gate, top-contact (BGTC) organic field effect transistors comprising a pentacene or a sexithiophene layer on random arrays of carbon nanotubes (CNT). The random arrays of CNT are prepared by spray-coating a dispersion of CNT. The random arrays of CNT do not form connected paths between source-drain electrodes. The highest mobility is reached for a bottom-gate, top-contact (BGTC) OFET comprising pentacene and is 1.20 cm²/Vs.

Gen-Wen Hsieh, Flora M. Li, Paul Beecher, Arokia Nathan, Yiliang Wu, Beng S. Ong and William I. Milne, Journal of Applied Physics, 2009, 106, 123706 describe a bottom-gate, bottom-contact (BGBC) organic field effect transistor comprising a bilayer containing a poly[5,5'-bis(3-dodecyl-2-thienyl)-2,2'-bithiophene (PQT-12) layer obtained by ink jet printing on top of a thin non-percolating single-walled carbon nanotube (SWCNT) layer obtained by ink-jet printing a dispersion of isolated SWCNTs. The mobility of the OFET is 0.228 cm²/Vs.

US2011121273A disclose a carbon nanotube (CNT) composite in which a conjugated polymer containing repeating units containing a fused heteroaryl unit having a nitrogen-containing double bond in the ring and a thiophene ring is attached to at least a part of the surface of a carbon nanotube, and field effect transistors having a semiconducting layer containing the CNT composites. The semiconducting layer is either a CNT composite layer, a layer comprising CNT composite dispersed in a semiconductor or as bilayer wherein one layer comprises the CNT composite and the other layer comprises organic semiconductor. Object was an organic field effect transistor of low hysteresis.

US20130048949A1 discloses bottom-gate, bottom-contact (BGBC) thin film transistor (TFT) devices incorporating a thin film semiconductor derived from carbonaceous nanomaterials and a dielectric layer composed of an organic-inorganic hybrid self-assembled multilayer. The carbonaceous nanomaterials can be single or multi-walled carbon nanotubes, preferably mostly semiconducting carbon nanotubes with about 1% or less metallic CNT. In the exemplified bottom-gate, bottom-contact (BGBC) TFT using 99% pure semiconducting single-walled carbon nanotubes (sc-SWCNT) mobilities of 1 to 5 cm²/Vs and on-off current ratios of > 10³.

Smithson, C; Wu, Y.; Wigglesworth, T.; Gardner, S.; Zhu, S.; Nie H.-Y., Organic Electronics 2014, 15, 2639-2646 describes the fabrication of an organic thin film transistor comprising a composite of a semiconducting copolymer of diketopyrrolopyrrole-quarterthiophene (DPP-QT) and a mixture of metallic and semiconducting single-walled carbon nanotubes (SWCNTs). The maximum mobility for a DPP-QT and SWCNT composite in a bottom-gate, top-contact (BGTC) organic field effect transistor was 1.3 cm²/Vs.

Ting Lei, Ying-Chih Lai, Guonsong Hong, Huiliang Wang, Pascal Hayoz, R. Thomas Weitz, Changxin Chen, Hongjie Dai and Zhenan Bao, Small, 2015, 11, 24, 2946-2954 disclose bottom-gate, bottom-contact (BGBC) thin film transistors (TFTs) containing a semiconducting layer of semiconducting single walled carbon nanotubes with diameters mainly around 1.5 nm. The TFT showed high mobilities of 41.2 cm²/Vs and high on/off ratios of greater than 10⁴. The semiconducting single-walled carbon nanotube layer was obtained by soaking the substrate in a solution of diketopyrrolopyrrole (DPP)-based polymer wrapped semiconducting single-walled carbon nanotubes in toluene, followed by rinsing with toluene to remove most of the DPP-based polymer.

Tae-Jun Ha, Daisuke Kiriya, Kevin Chen, Ali Javey, Applied Materials & Interfaces 2014, 6, 8441 to 8446 describe hysteresis-free carbon nanotube bottom-gate, top-contact (BGTC) organic field effect transistors employing a fluoropolymer Teflon-AF layer on top of the carbon nanotube layer. The OFET also shows also operation stability in air and in water. Instead of the fluoropolymer Teflon AF layer, a fluoropolymer Cytop layer, a poly(methylmethacrylate) (PMMA) layer or a parylene C layer is also used. US 2012/187379 A1 discloses a thin film transistor with a dual semiconducting layer comprising two semiconducting sublayers. The first sublayer comprises a polythiophene and carbon nanotubes. The second sublayer comprises the polythiophene and has no carbon nanotubes. The polythiophene can comprise diketopyrrolopyrrole units.

The known methods for the preparation of organic field effect transistor comprising single-walled carbon nanotubes still show deficiencies.

It was the object of the present invention to provide organic field effect transistors of improved performance, in particular to provide organic field effect transistors showing low hysteresis and at the same time high mobilities.

The object is solved by the organic field effect transistor of claim 1 and the process for the preparation of an organic field effect transistor of claim 8.

The organic field effect transistor of the present invention comprises a double layer consisting of
i) a first layer comprising a percolating network of single-walled carbon nanotubes having a content of at least 95% by weight of semiconducting single-walled carbon nanotubes, and
ii) a second layer comprising an organic semiconducting material.

The first layer consists of a percolating network of single-walled carbon nanotubes or (in an embodiment not forming part of the claimed invention) the first layer can in addition to the percolating network of single-walled carbon nanotubes comprise additional materials. Examples of additional materials are bile salts such as sodium cholate, sodium dodecyl sulfate or organic semiconducting materials. The organic semiconducting materials of the first layer can be any of the organic semiconducting materials of the second layer listed below. The organic semiconducting materials of the first layer and the organic semiconducting materials of the second layer can be the same or different.

If the first layer consists of a percolating network of single-walled carbon nanotubes, the percolating network is a two-dimensional network of single-walled carbon nanotubes.

If the first layer in addition to the percolating network of single-walled carbon nanotubes comprise additional materials, the percolating network is a three-dimensional network of single-walled carbon nanotubes.

A percolating network of single-walled carbon nanotubes is a network of single-walled carbon nanotubes which establishes a connection between the source and drain electrodes.

A connection between the source and drain electrodes is established, if the average density of single-walled carbon nanotubes is above five single-walled carbon nanotubes per µm² for a two-dimensional network of single-walled carbon nanotubes, and above twenty single-walled carbon nanotubes per µm² for a three-dimensional network of single-walled carbon nanotubes. The average density of single-walled carbon nanotubes in the first layer can be determined by scanning electron microscopy (SEM).

Most preferably, the percolating network of single-walled carbon nanotubes have a content of at least 99% by weight of semiconducting single-walled carbon nanotubes.

The single-walled carbon nanotubes can have a diameter in the range of 0.5 to 10 nm. Preferably the single-walled carbon nanotubes have a diameter of 0.5 to 3 nm, more preferably 0.5 to 2 nm.

The single-walled carbon nanotubes can have a length in the range of 0.001 to 10⁴ µm. Preferably, the single-walled carbon nanotubes have a length in the range of 0.1 to 100 µm, more preferably 0.1 to 10 µm, even more preferably 0.05 to 1 µm, and most preferably 0.05 to 0.5 µm.

Single-walled carbon nantotubes (SWCNTs) can be grown by various methods known in the art such as high pressure carbon monoxide decomposition (HiPCO), Co-Mo catalysis (CoMoCAT), laser ablation, arc discharge and chemical vapor deposition (CVD). The SWCNTs obtained by these methods vary in their tube diameter, length and wrapping angle, and are mixtures of semiconducting and metallic SWCNTs. There are several post-growth methods for enriching the amount of semiconducting SWCNT from a mixture of semiconducting and metallic SWCNTs.

Ralph Krupke, Frank Hennrich , Hibert von Löhneysen and Manfred M. Kappes, Science 2003, 301, 344 to 347 describe separation of metallic and semiconducting SWCNT by alternating current dielectrophoresis.

Michael S. Arnold , Alexander A. Green , James F. Hulvat , Samuel I. Stupp and Mark C. Hersam , Nature Nanotechnology 2006 ,1 , 60 to 65 describe separation of metallic and semiconducting SWCNT by density gradient ultracentrifugation in the presence of bile salts such as sodium cholate as surfactants.

Yasumitsu Miyata, Kazunari shiozwa, Yukiasada, Yutaka Ohno, Ryo Kitaura, Takashi Mitzutani and Hisanori Shinohara, Nano Research 2011, 4(10), 963-970 describe a process for enriching semiconducting SWCNT from a mixture of semiconducting and metallic SWCNT including centrifugation of the mixture of SWCNTs and sodium cholate, separation of the supernatant and addition of sodium dodecyl sulfate to the supernatant, followed by gel filtration of the supernatant.

Enriched semiconducting single-walled carbon nanotubes together with conjugated polymers can be obtained by dispersion of a mixture of semiconducting and metallic SWCNT with a conjugated polymer, followed by centrifugation. For example, Kojiro Akazaki , Fumiyuki Toshimitsu, Hiroaki Ozawa , Tsuyohiko Fujigaya , Naotoshi Nakashima, Journal of the American Chemical Society 2012 , 134 , 12700 to 12707 describe such an enrichment process using fluorene binaphthol polymers as conjugated polymer. For example, Ting Lei, Ying-Chih Lai, Guonsong Hong, Huiliang Wang, Pascal Hayoz, R. Thomas Weitz, Changxin Chen, Hongjie Dai and Zhenan Bao, Small, 2015, 11, 24, 2946-2954 describe such an enrichment process using a diketopyrrolopyrrole-based polymer as conjugated polymer.

Single-walled carbon nanotubes enriched in semiconducting single-walled carbon nanotbubes are also commercially available from various companies such Nanointegris Incorporation or Southwest Nanotechnologies Incorporation.

Organic semiconducting materials are known in the prior art, as listed here below. The organic semiconducting material can be a small molecule or a polymer." "

Examples of organic semiconducting materials are polycyclic aromatic hydrocarbons consisting of linearly-fused aromatic rings such as anthracene, pentacene and derivatives thereof, polycyclic aromatic hydrocarbons consisting of two-dimensional fused aromatic rings such as perylene, perylene diimide derivatives, perylene dianhydride derivatives and naphthalene diimide derivatives, triphenylamine derivatives, oligomers and polymers containing aromatic units such as oligothiophene, oligophenylenevinylene, polythiophene, polythienylenevinylene polyparaphenylene, polypyrrole and polyaniline, hydrocarbon chains such as polyacetylenes, and diketopyrrolopyrrole-based materials.

For example, bis-alkinyl substituted polycyclic aromatic hydrocarbons consisting of linearly-fused aromatic rings are described in WO2007/068618.

For example, perylene diimide derivatives, perylene dianhydride derivatives and naphthalene diimide derivatives are described in WO2007/074137, WO2007/093643, WO2009/024512, WO2009/147237, WO2012/095790, WO2012/117089, WO2012/152598, WO2014/033622, WO2014/174435 and WO2015/193808.

For example, polymers comprising thiophene units are described in WO2010/000669, polymers comprising benzothiadiazol-cyclopentadithiophene units are described in WO2010/000755, polymers comprising dithienobenzathienothiophene units are described in WO2011/067192, polymers comprising dithienophthalimide units are described in WO2013/004730, polymers comprising thienothiophene-2,5-dione units as described in WO2012/146506, and polymers comprising Isoindigo-based units are described in WO2009/053291.

For example, diketopyrrolopyrrole-based materials and their synthesis are described in WO2005/049695, WO2008/000664, WO2010/049321, WO2010/049323, WO2010/108873, WO2010/136352, WO2010/136353, WO2012/041849, WO2012/175530, WO2013/083506, WO2013/083507 and WO2013/150005.

A summary on diketopyrrolopyrrole (DPP) based polymers suitable as semiconducting material in organic field effect transistors are also given in Christian B. Nielsen, Mathieu Turbiez and lain McCulloch, Advanced Materials 2013, 25 , 1859 to 1880.

The diketopyrrolopyrrole-based material is
i) a diketopyrrolopyrrole-based polymer comprising units of formula R¹ 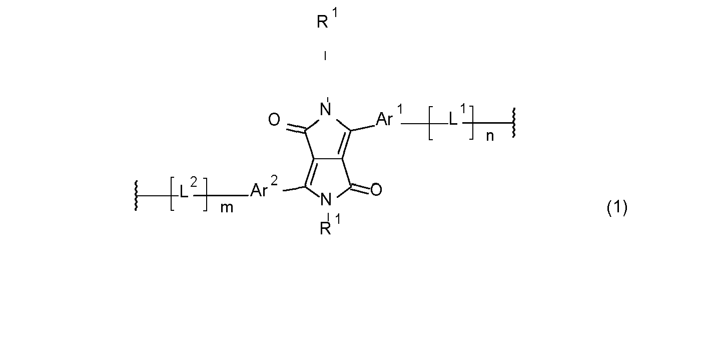 wherein
   R¹ is at each occurrence C₁₋₃₀-alkyl, C₂₋₃₀-alkenyl or C₂₋₃₀-alkynyl, wherein C₁₋₃₀-alkyl, C₂₋₃₀-alkenyl and C₂₋₃₀-alkynyl can be substituted by one or more -Si(R^{a})₃ or -OSi(R^{a})₃, or one or more CH₂ groups of C₁₋₃₀-alkyl, C₂₋₃₀-alkenyl and C₂₋₃₀-alkynyl can be replaced by -Si(R^{a})₂- or -[Si(R^{a})₂-O]ₐ-Si(R^{a})₂-,
      wherein R^{a} is at each occurrence C₁₋₁₀-alkyl, and a is an integer from 1 to 20,
   n and m are independently 0 or 1, and
   Ar¹ and Ar² are independently arylene or heteroarylene, wherein arylene and heteroarylene can be substituted with one or more C₁₋₃₀-alkyl, C₂₋₃₀-alkenyl, C₂₋₃₀-alkynyl, O-C₁₋₃₀ alkyl, aryl or heteroaryl, which C₁₋₃₀-alkyl, C₂₋₃₀-alkenyl, C₂₋₃₀-alkynyl, O-C₁₋₃₀ alkyl, aryl and heteroaryl can be substituted with one or more C₁₋₂₀-alkyl, O-C₁₋₂₀-alkyl or phenyl,
   L¹ and L² are independently selected from the group consisting of 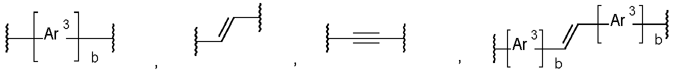 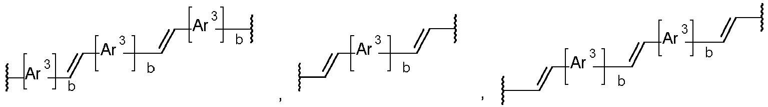 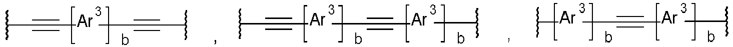 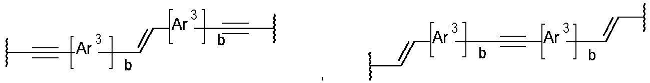 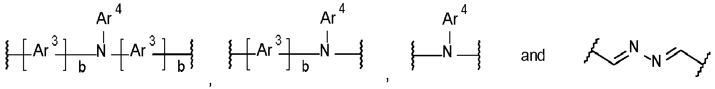
   wherein
   Ar³ is at each occurrence arylene or heteroarylene, wherein arylene and heteroarylene can be substituted with one or more C₁₋₃₀-alkyl, C₂₋₃₀-alkenyl, C₂₋₃₀-alkynyl, O-C₁₋₃₀-alkyl, aryl or heteroaryl, which C₁₋₃₀-alkyl, C₂₋₃₀-alkenyl, C₂₋₃₀-alkynyl, O-C₁₋₃₀-alkyl, aryl and heteroaryl can be substituted with one or more C₁₋₂₀-alkyl, O-C₁₋₂₀-alkyl or phenyl; and wherein adjacent Ar³ can be connected via a CR^{b}R^{b}, SiR^{b}R^{c} or GeR^{b}R^{b} linker, wherein R^{b} is at each occurrence H, C₁₋₃₀₋alkyl or aryl, which C₁₋₃₀₋alkyl and aryl can be substituted with one or more C₁₋₂₀-alkyl, O-C-₁₋₂₀-alkyl or phenyl,
   b is at each occurrence an integer from 1 to 8, and
   Ar⁴ is at each occurrence aryl or heteroaryl, wherein aryl and heteroaryl can be substituted with one or more C₁₋₃₀-alkyl, O-C₁₋₃₀ alkyl or phenyl, which phenyl can be substituted with C₁₋₂₀-alkyl or O-C₁₋₂₀-alkyl,
      or
i) a diketopyrrolopyrrole-based small molecule of formulae 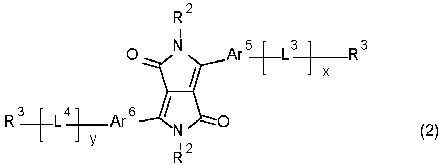 or 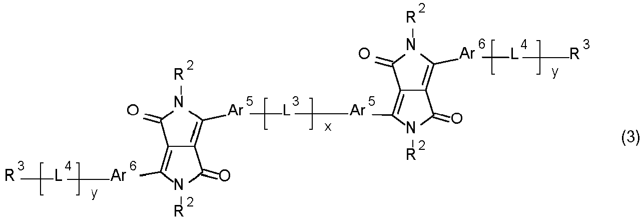 wherein
   R² is at each occurrence C₁₋₃₀-alkyl, C₂₋₃₀-alkenyl or C₂₋₃₀-alkynyl, wherein C₁₋₃₀-alkyl, C₂₋₃₀-alkenyl and C₂₋₃₀-alkynyl can be substituted by -Si(R^{c})₃ or -OSi(R^{c})₃, or one or more CH₂ groups of C₁₋₃₀-alkyl, C₂₋₃₀-alkenyl and C₂₋₃₀-alkynyl can be replaced by -Si(R^{c})₂- or -[Si(R^{c})₂-O]ₐ-Si(R^{c})₂-,
      wherein R^{c} is at each occurrence C₁₋₁₀-alkyl, and a is an integer from 1 to 20,
   R³ is H, CN, C₁₋₂₀-alkyl, C₂₋₂₀-alkenyl, C₂₋₂₀-alkynyl, O-C₁₋₂₀ alkyl, aryl or heteroaryl, which C₁₋₂₀-alkyl, C₂₋₂₀-alkenyl, C₂₋₂₀-alkynyl, O-C₁₋₂₀ alkyl, aryl and heteroaryl can be substituted with one or more C₁₋₆-alkyl, O-C₁₋₆-alkyl or phenyl,
   x and y are independently 0 or 1, and
   Ar⁵ and Ar⁶ are independently arylene or heteroarylene, wherein arylene and heteroarylene can be substituted with one or more C₁₋₃₀-alkyl, C₂₋₃₀-alkenyl, C₂₋₃₀-alkynyl, O-C₁₋₃₀-alkyl, aryl or heteroaryl, which C₁₋₃₀-alkyl, C₂₋₃₀-alkenyl, C₂₋₃₀-alkynyl, O-C₁₋₃₀-alkyl, aryl and heteroaryl can be substituted with one or more C₁₋₂₀-alkyl, O-C₁₋₂₀-alkyl or phenyl;
   L³ and L⁴ are independently selected from the group consisting of 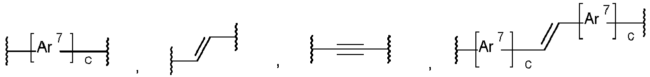 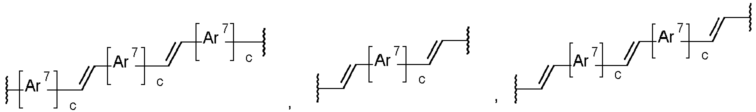 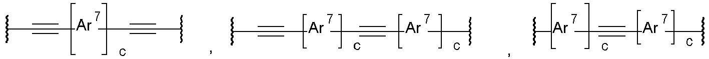 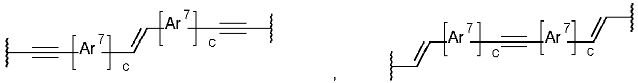 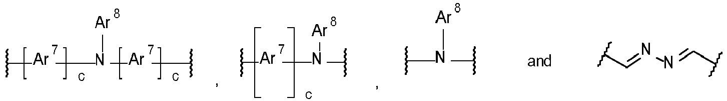
   wherein
   Ar⁷ is at each occurrence arylene or heteroarylene, wherein arylene and heteroarylene can be substituted with one or more C₁₋₃₀-alkyl, C₂₋₃₀-alkenyl, C₂₋₃₀-alkynyl, O-C₁₋₃₀-alkyl, aryl or heteroaryl, which C₁₋₃₀-alkyl, C₂₋₃₀-alkenyl, C₂₋₃₀-alkynyl, O-C₁₋₃₀-alkyl, aryl and heteroaryl can be substituted with one or more C-₁₋₂₀-alkyl, O-C-₁₋₂₀-alkyl or phenyl; and wherein adjacent Ar⁷ can be connected via an CR^{d}R^{d}, SiR^{d}R^{d} or GeR^{d}R^{d} linker, wherein R^{d} is at each occurrence H, C₁₋₃₀-alkyl or aryl, which C₁₋₃₀-alkyl and aryl can be substituted with one or more C₁₋₂₀-alkyl, O-C₁₋₂₀-alkyl or phenyl,
   c is at each occurrence an integer from 1 to 8, and
   Ar⁸ is at each occurrence aryl or heteroaryl, wherein aryl and heteroaryl can be substituted with one or more C₁₋₃₀-alkyl, O-C₁₋₃₀-alkyl or phenyl, which phenyl can be substituted with C₁₋₂₀-alkyl or O-C₁₋₂₀-alkyl.

C₁₋₆-alkyl, C₁₋₁₀-alkyl, C₁₋₂₀-alkyl, C₁₋₃₀-alkyl and C₆₋₃₀-alkyl can be branched or unbranched (linear). If branched, C₁₋₆-alkyl, C₁₋₁₀-alkyl, C₁₋₂₀-alkyl and C₁₋₃₀-alkyl are preferably branched at the C2-atom. Examples of C₁₋₆-alkyl are methyl, ethyl, *n*-propyl, isopropyl, *n-*butyl*,* sec-butyl, isobutyl, *tert-*butyl*, n*-pentyl, neopentyl, isopentyl, *n*-(1-ethyl)propyl and *n*-hexyl. Examples of C₁₋₁₀-alkyl are C₁₋₆-alkyl and *n*-heptyl, *n*-octyl, *n-*(2-ethyl)hexyl, *n*-nonyl, *n*-decyl. Examples of C₁₋₂₀-alkyl are C₁₋₁₀-alkyl and *n*-undecyl, n-dodecyl, *n*-undecyl, n-dodecyl, *n*-tridecyl, *n*-tetradecyl, *n*-(2-butyl)decyl, *n*-pentadecyl, n-hexadecyl, *n*-heptadecyl, *n*-octadecyl, *n*-nonadecyl, *n*-(2-hexyl)tetradecyl and *n*-icosyl (C₂₀). Examples of C₁₋₃₀-alkyl are C₁₋₂₀-alkyl and *n-*docosyl (C₂₂), *n*-(2-decyl)dodecyl, *n*-tetracosyl (C₂₄), *n*-hexacosyl (C₂₆), *n*-octacosyl (C₂₈) and *n*-triacontyl (C₃₀). Examples of C₆₋₃₀-alkyl are *n*-hexyl, *n*-heptyl, *n*-octyl, *n*-(2-ethyl)hexyl, *n*-nonyl, *n*-decyl, *n*-undecyl, *n*-dodecyl, *n*-undecyl, *n*-dodecyl, *n*-tridecyl, *n*-tetradecyl, *n*-(2-butyl)decyl, *n*-pentadecyl, *n*-hexadecyl, *n*-heptadecyl, *n*-octadecyl, *n*-nonadecyl, *n*-(2-hexyl)tetradecyl, *n*-icosyl , *n*-docosyl (C₂₂), *n*-(2-decyl)dodecyl, *n*-tetracosyl (C₂₄), *n*-hexacosyl (C₂₆), *n*-octacosyl (C₂₈) and n-triacontyl (C₃₀).

Examples of linear C₆₋₁₄-alkyl are *n*-hexyl, *n*-heptyl, *n*-octyl, *n*-nonyl, *n*-decyl, *n*-undecyl, *n*-dodecyl, *n*-undecyl, *n*-dodecyl, *n*-tridecyl and *n*-tetradecyl.

Examples of linear C₂₋₁₂-alkyl are ethyl, *n*-propyl, isopropyl, *n*-butyl, *n*-pentyl, *n*-hexyl. *n*-heptyl, *n*-octyl, *n*-nonyl, *n*-decyl, *n*-undecyl and *n*-dodecyl.

C₂₋₃₀-alkenyl can be branched or unbranched. Examples of C₂₋₃₀-alkenyl are vinyl, propenyl, cis-2-butenyl, trans-2-butenyl, 3-butenyl, cis-2-pentenyl, trans-2-pentenyl, cis-3-pentenyl, trans-3-pentenyl, 4-pentenyl, 2-methyl-3-butenyl, hexenyl, heptenyl, octenyl, nonenyl, docenyl, linoleyl (C₁₈), linolenyl (C₁₈), oleyl (C₁₈), and arachidonyl (C₂₀), and erucyl (C₂₂).

C₂₋₃₀-alkynyl can be branched or unbranched. Examples of C₂₋₃₀-alkynyl are ethynyl, 2-propynyl, 2-butynyl, 3-butynyl, pentynyl, hexynyl, heptynyl, octynyl, nonynyl, decynyl, undecynyl, dodecynyl, undecynyl, dodecynyl, tridecynyl, tetradecynyl, pentadecynyl, hexadecynyl, heptadecynyl, octadecynyl, nonadecynyl and icosynyl (C₂₀).

Arylene is a bivalent aromatic ring system, consisting of one aromatic ring or of two to eight condensed aromatic rings, wherein all rings are formed from carbon atoms. Preferably, arylene is a bivalent aromatic ring system consisting of one aromatic ring or of two to four condensed aromatic rings, wherein all rings are formed from carbon atoms.

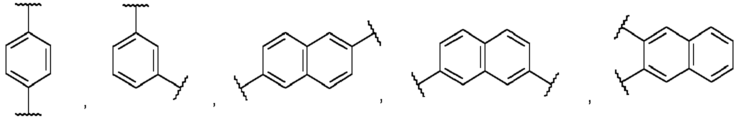

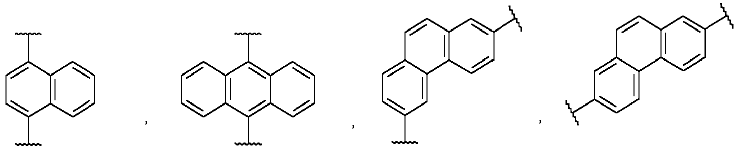

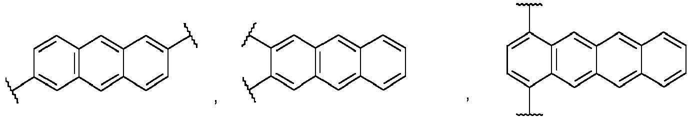

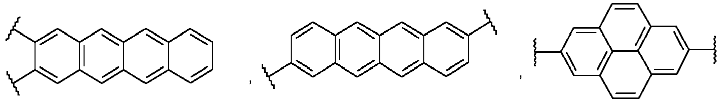

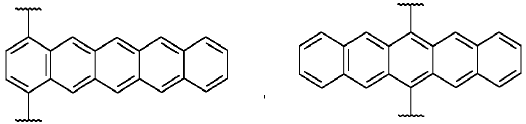

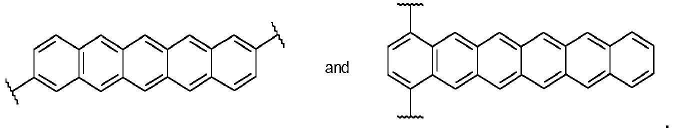

Heteroarylene is a bivalent aromatic ring system consisting of one aromatic ring or of two to eight condensed aromatic rings, wherein at least one aromatic ring contains at least one heteroatom selected from the group consisting of S, O, N and Se. Preferably, heteroarylene is a bivalent aromatic ring system consisting of one aromatic ring or of two to four condensed aromatic rings, wherein at least one aromatic ring contains at least one heteroatom selected from the group consisting of S, O, N and Se.

Examples of heteroarylene are 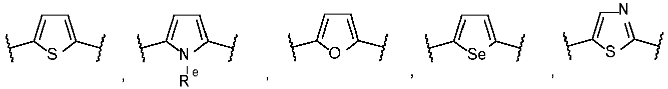 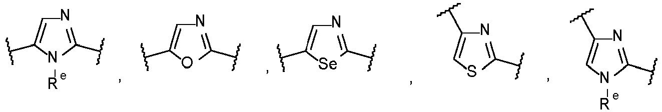 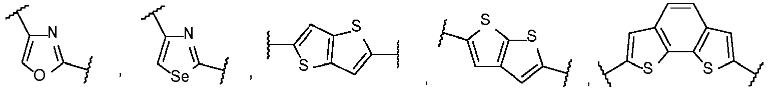 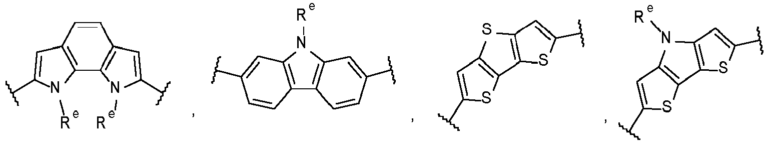 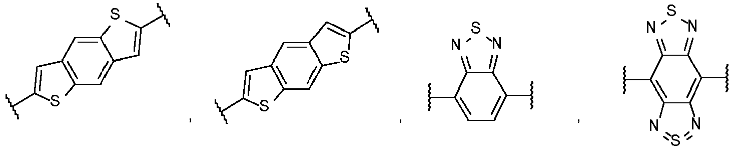 and 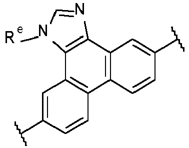 wherein R^{e} is H, C-₁₋₂₀-alkyl, aryl or heteroaryl, which C-₁₋₂₀-alkyl, aryl and heteroaryl can be substituted with one or more C₁₋₆-alkyl, O-C₁₋₆-alkyl or phenyl.

Examples of adjacent Ar³, which are connected via a CR^{b}R^{b}, SiR^{b}R^{c} or GeR^{b}R^{b} linker, wherein R^{b} is at each occurrence H, C₁₋₃₀-alkyl or aryl, which C₁₋₃₀-alkyl and aryl can be substituted with one or more C₁₋₂₀-alkyl, O-C-₁₋₂₀-alkyl or phenyl, and b is at each occurrence an integer from 1 to 8, are

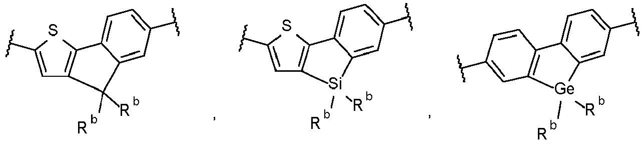

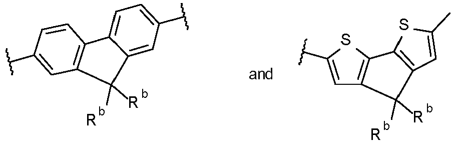

Examples of adjacent Ar⁷, which are connected via an CR^{d}R^{d}, SiR^{d}R^{d} or GeR^{d}R^{d} linker, wherein R^{d} is at each occurrence H, C₁₋₃₀-alkyl or aryl, which C₁₋₃₀-alkyl and aryl can be substituted with one or more C₁₋₂₀-alkyl, O-C-₁₋₂₀-alkyl or phenyl, and c is at each occurrence an integer from 1 to 8, are

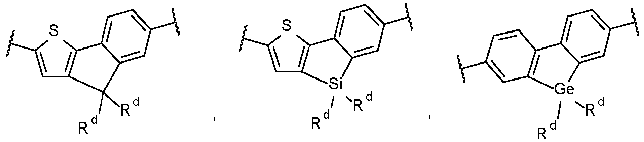

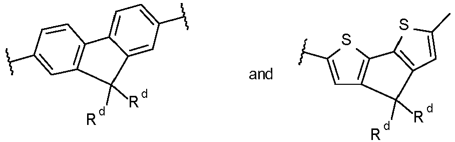

Aryl is a monovalent aromatic ring system, consisting of one aromatic ring or of two to eight condensed aromatic rings, wherein all rings are formed from carbon atoms. Preferably, aryl is a monovalent aromatic ring system consisting of one aromatic ring or of two to four condensed aromatic rings, wherein all rings are formed from carbon atoms.

Examples of aryl are 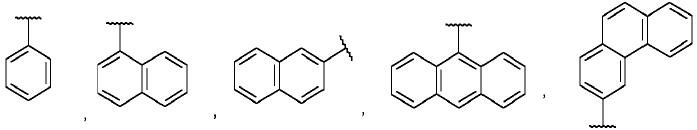 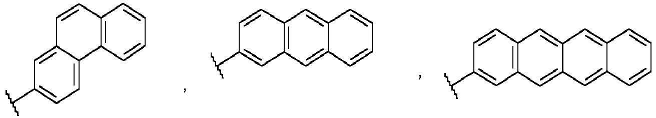 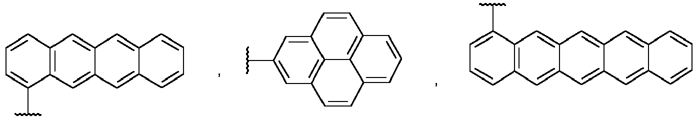 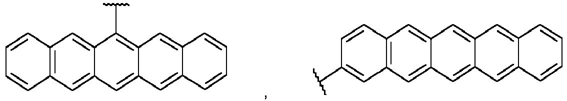 and

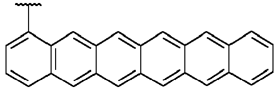

Heteroaryl is a monovalent aromatic ring system consisting of one aromatic ring or of two to eight condensed aromatic rings, wherein at least one aromatic ring contains at least one heteroatom selected from the group consisting of S, O, N and Se. Preferably, heteroaryl is a monovalent aromatic ring system consisting of one aromatic ring or of two to four condensed aromatic rings, wherein at least one aromatic ring contains at least one heteroatom selected from the group consisting of S, O, N and Se.

Examples of heteroaryl are 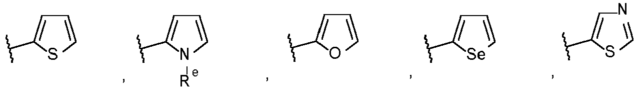 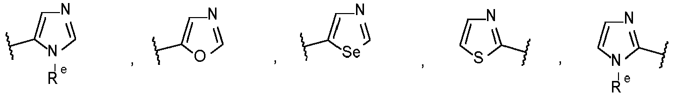 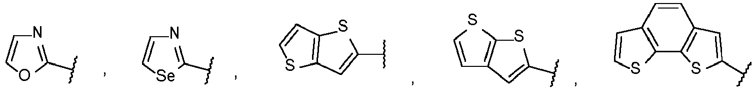 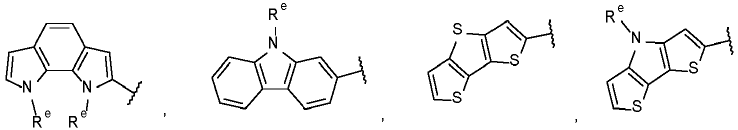 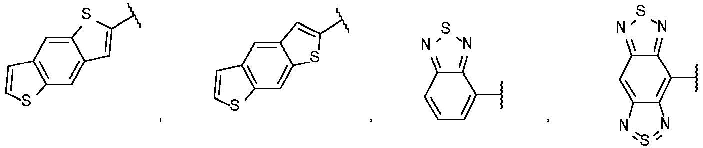 and

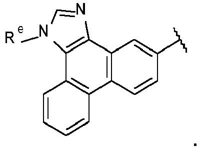

Examples of L', L², L³ and L⁴ are

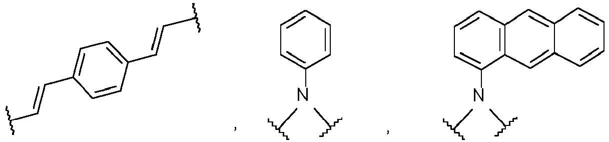

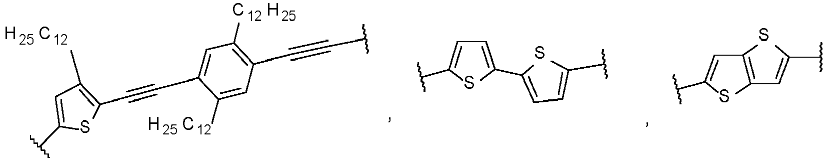

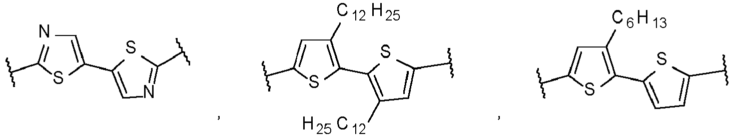

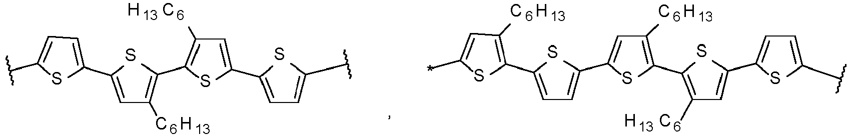

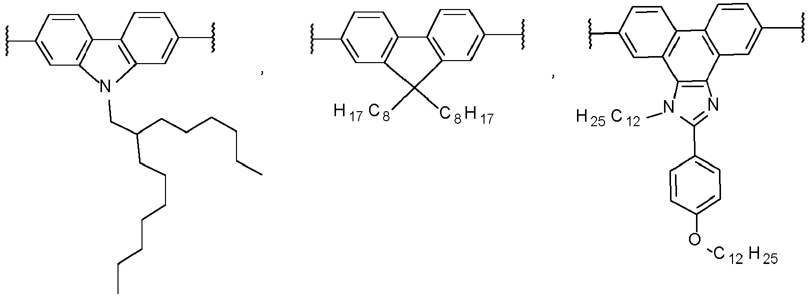

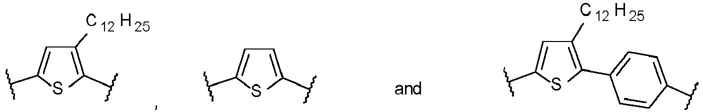

More preferably, the diketopyrrolopyrrole-based material is a diketopyrrolopyrrole-based polymer comprising units of formula (1) as defined above.

The diketopyrrolopyrrole-based polymers comprising units of formula (1) can comprise other conjugated units. The diketopyrrolopyrrole-based polymers comprising units of formula (1) can be homopolymers or copolymers. The copolymers can be random or block.

Preferably, the diketopyrrolopyrrole-based polymers comprise at least 50% by weight of units of formula (1) based on the weight of the polymer, more preferably at least 70%, even more preferably at least 90% by weight of units of formula (1) based on the weight of the polymer. Most preferably, diketopyrrolopyrrole-based polymers essentially consist of units of formula (1). The diketopyrrolopyrrole-based polymers essentially consisting of units of formula (1) can be homopolymers or copolymers.

According to the claimed invention, the diketopyrrolopyrrole-based material is a diketopyrrolopyrrole-based polymer consisting of units of formula 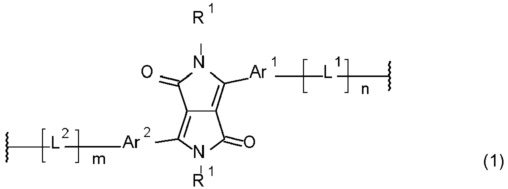 wherein
R¹ is C₆₋₃₀-alkyl,
n and m are independently 0 or 1, provided n and m are not both 0, and
Ar¹ and Ar² are independently 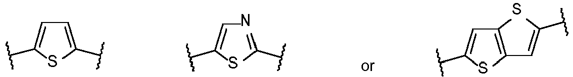
L¹ and L² are independently selected from the group consisting of 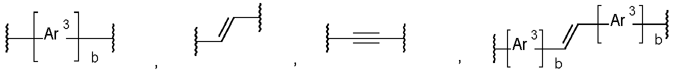 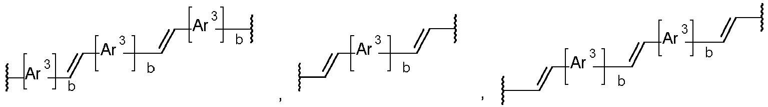 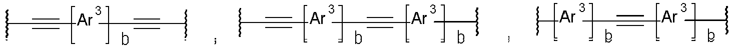 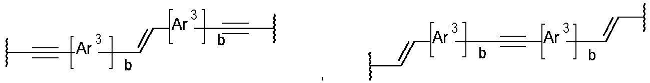 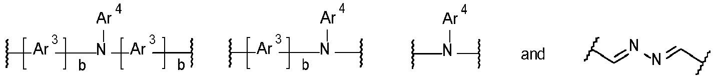
wherein
Ar³ is at each occurrence arylene or heteroarylene, wherein arylene and heteroarylene can be substituted with one or more C₁₋₃₀-alkyl, C₂₋₃₀-alkenyl, C₂₋₃₀-alkynyl, O-C₁₋₃₀-alkyl, aryl or heteroaryl, which C₁₋₃₀-alkyl, C₂₋₃₀-alkenyl, C₂₋₃₀-alkynyl, O-C₁₋₃₀-alkyl, aryl and heteroaryl can be substituted with one or more C-₁₋₂₀-alkyl, O-C₁₋₂₀-alkyl or phenyl; and wherein adjacent Ar³ can be connected via a CR^{b}R^{b}, SiR^{b}R^{c} or GeR^{b}R^{b} linker, wherein R^{b} is at each occurrence H, C₁₋₃₀₋alkyl or aryl, which C₁₋₃₀-alkyl and aryl can be substituted with one or more C₁₋₂₀-alkyl, O-C₁₋₂₀-alkyl or phenyl,
b is at each occurrence an integer from 1 to 8, and
Ar⁴ is at each occurrence aryl or heteroaryl, wherein aryl and heteroaryl can be substituted with one or more C₁₋₃₀-alkyl, O-C₁₋₃₀-alkyl or phenyl, which phenyl can be substituted with C₁₋₂₀-alkyl or O-C₁₋₂₀-alkyl.

Most preferably, the diketopyrrolopyrrole-based material is a diketopyrrolopyrrole-based polymer consisting of units of formula 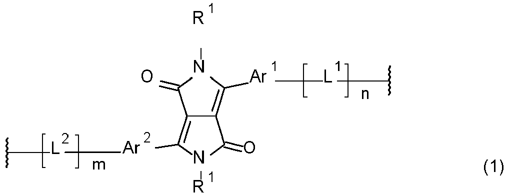 wherein
R¹ is 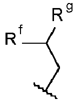
wherein
R^{f} is linear C₆₋₁₄-alkyl, and
R^{g} is linear C₂₋₁₂-alkyl,
n and m are independently 0 or 1, provided n and m are not both 0, and
Ar¹ and Ar² are 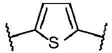
L¹ and L² are independently selected from the group consisting of 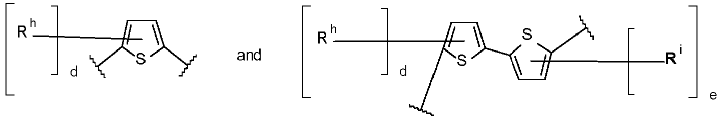
wherein
R^{h} and Rⁱ are independently C₆₋₃₀-alkyl, and
d and e are independently 0 or 1.

In particular, the diketopyrrolopyrrole-based material is a diketopyrrolopyrrole-based polymer consisting of units of formula

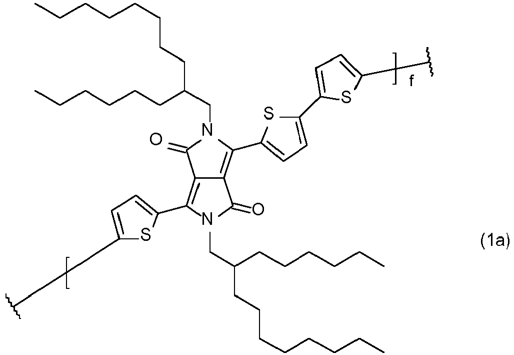

Preferably the second layer consists of organic semiconducting material.

The second layer can have a thickness of 5 to 500 nm, preferably of 10 to 100 nm, more preferably of 20 to 50 nm.

The organic field effect transistor of the present invention usually also comprises a dielectric layer, a gate electrode and source and drain electrodes. In addition, the organic field effect transistor of the present invention can comprise other layers such as a self-assembled monolayers (SAMs) or adhesion layers.

The dielectric layer can comprise any dielectric material known in the art or mixtures thereof. The dielectric material can be silicon dioxide or aluminium oxide, or, an organic polymer such as polystyrene (PS) and polystyrene derived polymers, polymethylmethacrylate) (PMMA), poly(4-vinylphenol) (PVP), poly(vinyl alcohol) (PVA), benzocyclobutene (BCB), or polyimide (PI). The dielectric layer can have a thickness of 10 to 2000 nm, preferably of 50 to 1000 nm, more preferably of 100 to 800 nm.

The self-assembled monolayer can comprise organic silane derivates or organic phosphoric acid derivatives. An example of an organic silane derivative is octyltrichlorosilane. An examples of an organic phosphoric acid derivative is decylphosphoric acid.

The source/drain electrodes can be made from any suitable organic or inorganic source/drain material. Examples of inorganic source/drain materials are gold (Au), silver (Ag) or copper (Cu), as well as alloys comprising at least one of these metals. The source/drain electrodes can have a thickness of 1 to 100 nm, preferably from 20 to 70 nm.

The gate electrode can be made from any suitable gate material such as highly doped silicon, aluminium (Al), tungsten (W), indium tin oxide or gold (Au), or alloys comprising at least one of these metals. The gate electrode can have a thickness of 1 to 200 nm, preferably from 5 to 100 nm.

The substrate can be any suitable substrate such as glass, or a plastic substrate such as polyethersulfone, polycarbonate, polysulfone, polyethylene terephthalate (PET) and polyethylene naphthalate (PEN). Depending on the design of the organic field effect transistor, the gate electrode, for example highly doped silicon can also function as substrate.

The organic field effect transistor of the present invention can be a bottom-gate organic field effect transistor or a top-gate organic field effect transistor. Preferably, it is a bottom-gate organic field effect transistor.

Preferably, the organic field effect transistor of the present invention is a bottom-gate organic field effect transistor, wherein the second layer of the double layer is on top of the first layer of the double layer.

Preferably, the organic field effect transistor of the present invention is a bottom-gate organic field effect transistor, wherein the second layer of the double layer is on top of the first layer of the double layer, and wherein the first layer of the double layer is on top of an adhesion layer.

The adhesion layer can comprise any material suitable for improving the adhesion of the first layer. Preferably, the adhesion layer comprises at least one poly(amino acid). A poly(amino acid) is a polymer formed by polymerization of monomers comprising a carboxylic acid group or a carboxylic acid derivative group and an amino group. Preferably, the poly(amino acid) is hydrophilic. More preferably, the poly(amino acid) is polylysine, most preferably poly-L-lysine. Preferably, the poly(amino acid) layer is formed by immersion dip coating using a solution of the poly(amino acid) in a suitable solvent such as water. The concentration of the poly(amino acid) in the water can be in the range of 0.001 to 10 weight%, preferably in the range of 0.01 to 1 weight%. The poly(amino acids) can be formed by methods known in the art such as by polymerization of monomers comprising a carboxylic acid group or a carboxylic acid derivative group and an amino group. Alternatively, many poly(amino acids) are also commercially available, such as poly-L-lysine from Sigma Aldrich.

Also part of the present invention is a process for the preparation of the organic field effect transistor according to claim 1 comprising the .steps of
i) depositing a composition comprising single-walled carbon nanotubes having a content of at least 95% by weight of semiconducting single-walled carbon nanotubes in order to form a first layer comprising a percolating network of single-walled carbon nanotubes having a content of at least 95% by weight of semiconducting single-walled carbon nanotubes, and
ii) depositing a composition comprising organic semiconducting material in order to form a second layer comprising an organic semiconducting material.

The composition comprising single-walled carbon nanotubes having a content of at least 95% by weight of semiconducting single-walled carbon nanotubes usually comprises one or more solvents (not in accordance with the claimed invention) additional material. The additional material is defined above. The solvent can be any suitable solvent such as N-methyl-2-pyrrolidone, o-dichlorobenzene, chloroform, 1-cyclohexyl-2-pyrrolidinone, water or toluene. Preferably, the solvent is water.

The concentration of the single-walled carbon nanotubes in the composition can be in the range of 1 to 0.000001 weight%, preferably in the range of 0.01 to 0.0001 weight%. The composition comprising single-walled carbon nanotubes can be a dispersion or a solution, preferably, the composition is a solution.

The composition comprising single-walled carbon nanotubes can be deposited by any suitable method known in the art. Preferably, the composition is deposited by solution depositing techniques such as drop-casting, blade-coating, ink-jet printing and spin-coating. The deposition can be performed one time or several times. Preferably, the composition is deposited several, for example three, times. After the deposition, the deposited single-walled carbon nanotubes can be dried at elevated temperature such as temperatures in the range of 80 to 110°C, followed by rinsing with water in order to remove not deposited single-walled carbon nanotubes, followed by annealing at elevated temperatures such as 120 to 180°C. If additional materials are present in the composition, the composition can, after deposition, also be heated in order to remove the additional materials.

The composition comprising organic semiconducting material can also comprise one or more solvents. The solvent of the composition can be any suitable solvent such as toluene or o-xylene.

The concentration of the organic semiconducting material in the composition can be in the range of 0.01 to 5 weight%, preferably, in the range of 0.1 to 3 weight %, more preferably, in the range of 0.5 to 1.5 weight%. The composition comprising the organic semiconducting material can be a dispersion or a solution, preferably, it is a solution.

The composition comprising the organic semiconducting material can be deposited by any suitable method known in the art. Preferably, the composition is deposited by solution deposition techniques such as spin-coating, drop-coating, dip-coating, blade-coating or inkjet printing.

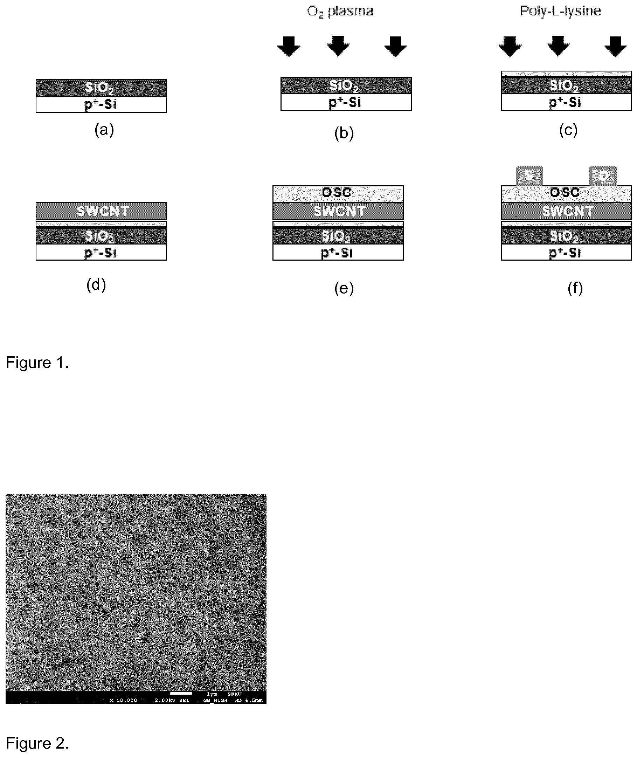

For example, a bottom-gate, top-contact (BGTC) organic field effect transistor (not forming part of the present invention) can be prepared as outlined in Figure 1. Heavily doped SiO₂ substrate (200 nm thickness), which also functions as gate dielectric, can be cleaned by various solvents using sonication (Figure 1a). Then, O₂ plasma can be applied to make the top surface hydrophilic (Figure 1b) and a poly(amino acid) solution such as an aqueous poly-L-lysine solution can be deposited, for example by immersion dip coating (Figure 1c). After rinsing the top surface with deionized water and drying at elevated temperature, a solution of single walled semiconducting carbon nanotubes (SWCNT) having a content of at least 80% by weight of semiconducting single-walled carbon nanotubes can be deposited, for example by drop casting, followed by drying at elevated temperature. The deposition of the solution of the single walled carbon nanotubes can be repeated twice (Figure 1d). After rinsing the top surface with deionized water and annealing the semiconducting single walled carbon nanotube layer at elevated temperature, a solution of the organic semiconducting (OSC) material can be deposited, for example by blade-coating at elevated temperatures (Figure 1e). Finally, source (S) and drain (D) electrode, for example of Au, can be deposited by thermal evaporation (Figure 1f). A passivation layer may optionally be deposited on the source and drain electrodes.

The organic field effect transistors of the present invention are particular advantageous as the transistors show high mobilities and low hysteresis.

The organic field effect transistors of the present are advantageous in that the transistors can be prepared by solution deposition techniques which allow the production of large areas.

The organic field effect transistors of the present are also advantageous in that the transistors show reproducible performances when produced under ambient conditions with regard to air and humidity, and also stable performance over time when stored under ambient conditions with regard to air and humidity.

Figure 1 shows a process for the preparation of a bottom-gate, top-contact (BGTC) organic field effect transistor of the present invention comprising a double layer consisting of i) a first layer comprising a percolating network of single-walled carbon nanotubes (SWCNT) having a content of at least 95% by weight of semiconducting single-walled carbon nanotubes, and ii) a second layer comprising an organic semiconducting material (OSC).

Figure 2 shows a field emission scanning electron microscope (FESEM) image of a first layer comprising a percolating network of single walled carbon nanotubes having a content of 99.9% by weight of semiconducting single-walled carbon nanotubes prepared by drop casting a commercially available single-walled carbon nanotube composition (IsoNanotubes-S^{™} having a content of semiconducting single-walled carbon nanotubes of 99.9%, from Nanointegris Inc., concentration of SWCNT in the solution was 0.001 wt%, diameter range: 1.2 to 1.7 nm, length range: 300 nm to 5 µm) on a poly-L-lysine adhesion layer.

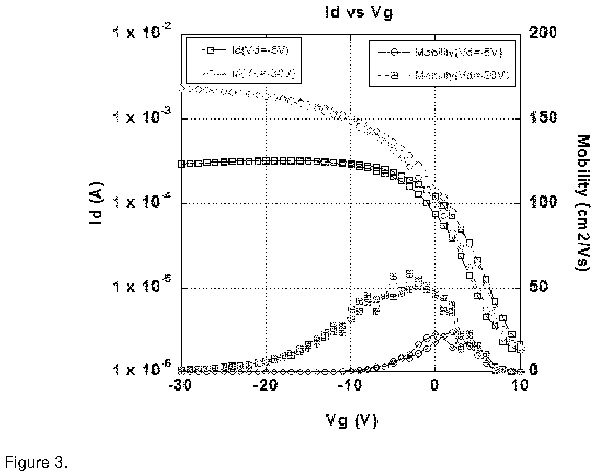

Figure 3 shows the transfer characteristics drain current (Id) against gate-source voltage (Vg) of the bottom-gate, top-contact (BGTC) organic field effect transistor of example 2 comprising polymer 1a as organic semiconducting material in the saturation regime, while the gate voltage was scanned from 10 to -30 V.

### Examples

### Example 1

### Preparation of semiconducting polymer of formula 1a

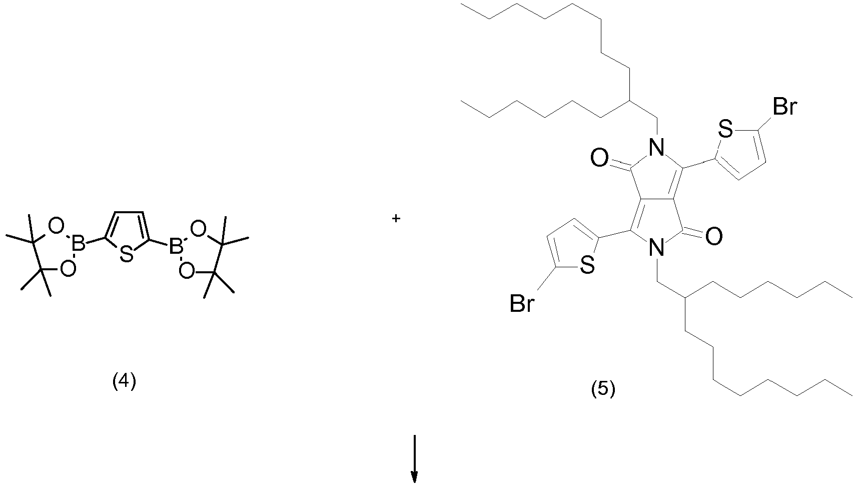

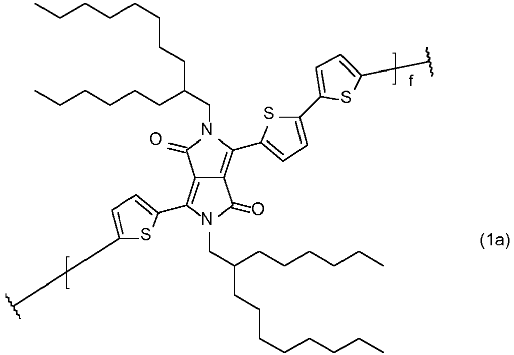

733 mg (2.181 mmol) of compound 4, 1972mg (2.181 mmol) of compound 5, 78.30 mg of tris(dibenzylideneacetone)dipalladium(0) (Pd₂(dba)₃) and 48.15 mg of tri-tert-butylphosphonium tetrafluoroborate ((*tert*-Bu)₃P x HBF₄) are placed together in 50 ml of tetrahydrofuran under Argon. The reaction mixture is heated to reflux, and then 1600 mg potassium phosphate in 5 ml of degassed water is added. The reaction mixture is refluxed overnight. Then, the reaction mixture is poured on water and the precipitate is filtered and washed with water and methanol. The precipitate is then Soxhlet fractionated with heptane, tetrahydrofuran, toluene, chloroform and chlorobenzene. To remove catalyst residues, the selected fraction is evaporated and the residue is dissolved in 150 ml of chlorobenzene. Then 50 ml of a 1% NaCN aqueous solution is added and the mixture is heated and stirred overnight at reflux. The phases are separated and the organic phase is washed 3 times with 10 ml of deionized water for 3 hours at reflux. Polymer **1a** is then precipitated from the organic phase by addition of methanol. The precipitated polymer **1a** is filtered, washed with methanol and dried. UV-VIS-absorption spectrum: λₘₐₓ: 840 nm (film) and 840 nm (10⁻⁵ M solution in toluene).

### Example 2

### Preparation of a bottom-gate, top-contact (BGTC) organic field effect transistor comprising a double layer consisting of a first layer essentially consisting of a percolating network of single-walled carbon nanotubes having a content of semiconducting single-walled carbon nanotubes of 99.9%, and a second layer essentially consisting of the diketopyrrolopyrrole-based polymer 1a of example 1

A bottom-gate, top-contact (BGTC) thin film transistor (TFT) with channel length (50 µm) and width (500 µm) was prepared. Heavily doped Si substrate (200 nm of SiO₂ thickness) was cleaned by acetone, isopropanol and deionized water using sonication for 1 min each time. Then, O₂ plasma was applied (100 sccm, 50 W for 60 sec) to make the surface hydrophilic. To enhance the adhesiveness of the surface to single-walled carbon nanotubes, poly-L-lysine solution (0.1 % w/v in water, Sigma Aldrich) was deposited by immersion technique for 5 min. Then, the surface was thoroughly rinsed with deionized water and dried at 95 °C on a hot plate for 1 min. Commercially available purified aqueous single-walled carbon nanotubes (SWCNT)solution (IsoNanotubes-S^{™} having a content of semiconducting single-walled carbon nanotubes of 99.9%, from Nanointegris Inc., concentration of SWCNT in the solution was 0.001 wt%, diameter range: 1.2 to 1.7 nm, length range: 300 nm to 5 µm) was deposited by drop casting onto the surface and baked at 95 °C on a hot plate for 3 min. The drop casting depositing of the SWCNT solution was repeated twice. After having placed the substrate with deposited SWCNTs in the air for 10 min, the substrate was dried 3 min at 95 °C on hot plate, followed by rinsing with water, carefully drying with N₂ gas and annealing at 150 °C on a hot plate for 1 h. A solution of 0.75 wt% semiconducting polymer of formula 1a of example 1 in toluene was blade-coated onto the SWCNT layer at 120 °C. The gap and speed of the blade coater was 100 µm and 30 mm/sec, respectively. Finally, source and drain electrode of Au were deposited (50 nm of thickness) by thermal evaporation.

A field emission scanning electron microscope (FESEM) image of the first layer essentially consisting of a percolating network of single-walled carbon nanotubes having a content of 99.9% by weight of semiconducting single-walled carbon nanotubes on the poly-L-lysine adhesion layer is shown in Figure 2.

### Example 3

### Electrical characterization of the bottom-gate, top-contact (BGTC) organic field effect transistor of example 2

The electrical characterization of the BGTC organic field effect transistor of example 2 was conducted under ambient condition at room temperature using Keithley 4200-SCS.

Figure 3 shows the transfer characteristics drain current (Id) against gate-source voltage (Vg) of the BGBC TFT of example 2 in the saturation regime, while the gate voltage was scanned from 10 to -30 V.

The saturation field effect mobility of the bilayer structure in active layer is 58 cm²/Vs. The lon/off is 10³.

## Claims

1. An organic field effect transistor comprising a double layer consisting of
i) a first layer comprising a percolating network of single-walled carbon nanotubes having a content of at least 95% by weight of semiconducting single-walled carbon nanotubes, and
ii) a second layer comprising an organic semiconducting material;
wherein the first layer consists of a percolating network of single-walled carbon nanotubes; and
wherein the organic semiconducting material is at least one diketopyrrolopyrrole-based material, wherein the diketopyrrolopyrrole-based material is a diketopyrrolopyrrole-based polymer consisting of units of formula 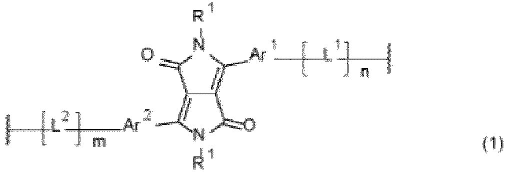
wherein
R¹ is C₆₋₃₀-alkyl,
n and m are independently 0 or 1, provided n and m are not both 0, and
Ar¹ and Ar² are independently 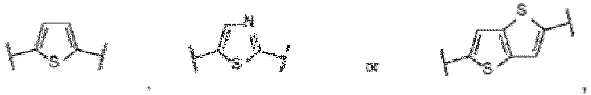
L¹ and L² are independently selected from the group consisting of ED 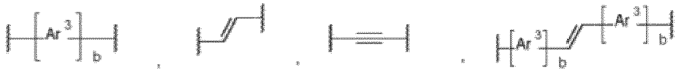 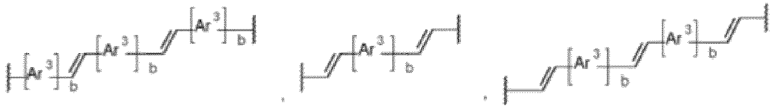 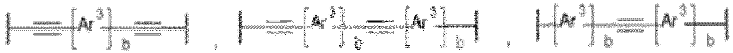 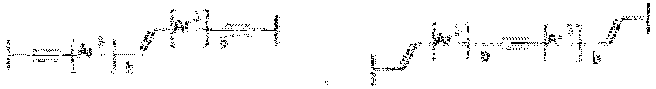 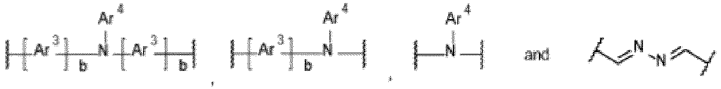
wherein
Ar³ is at each occurrence arylene or heteroarylene, wherein arylene and heteroarylene can be substituted with one or more C₁₋₃₀-alkyl, C₂₋₃₀-alkenyl, C₂₋₃₀-alkynyl, O-C₁₋₃₀-alkyl, aryl or heteroaryl, which C₁₋₃₀-alkyl, C₂₋₃₀-alkenyl, C₂₋₃₀-alkynyl, O-C₁₋₃₀-alkyl, aryl and heteroaryl can be substituted with one or more C₁₋₂₀-alkyl, O-C₁₋₂₀-alkyl or phenyl; and wherein adjacent Ar³ can be connected via a CR^{b}R^{b}, SiR^{b}R^{b} or GeR^{b}R^{b} linker, wherein R^{b} is at each occurrence H, C₁₋₃₀-alkyl or aryl, which C₁₋₃₀-alkyl and aryl can be substituted with one or more C₁₋₂₀-alkyl, O-C₁₋₂₀-alkyl or phenyl,
b is at each occurrence an integer from 1 to 8, and
Ar⁴ is at each occurrence aryl or heteroaryl, wherein aryl and heteroaryl can be substituted with one or more C₁₋₃₀-alkyl, O-C₁₋₃₀-alkyl or phenyl, which phenyl can be substituted with C₁₋₂₀-alkyl or O-C₁₋₂₀-alkyl.

2. The organic field effect transistor of claim 1, wherein the percolating network of single-walled carbon nanotubes have a content of at least 99% by weight of semiconducting single-walled carbon nanotubes.

3. The organic field effect transistor of any of claims 1 to 2, wherein the single-walled carbon nanotubes have a diameter of 0.5 to 3 nm, and a length in the range of 0.1 to 100 µm.

4. The organic field effect transistor of claim 1, wherein the diketopyrrolopyrrole-based material a diketopyrrolopyrrole-based polymer consisting of units of formula 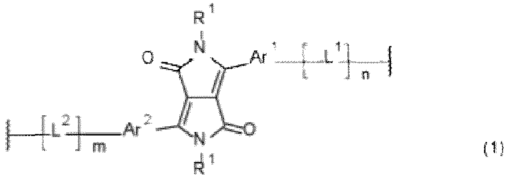 wherein
R1 is 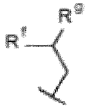
wherein
R^{f} is C₆₋₁₄-alkyl
R⁹ is C₂₋₁₂-alkyl,
n and m are independently 0 or 1, provided n and m are not both 0, and
Ar¹ and Ar² are 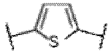
L¹ and L² are independently selected from the group consisting of 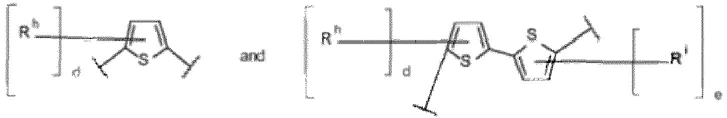
wherein
R^{h} and Rⁱ are independently C₆₋₃₀-alkyl, and
d and e are independently 0 or 1.

5. The organic field effect transistor of any of claims 1 to 4, wherein the organic field effect transistor is a bottom-gate organic field effect transistor.

6. The organic field effect transistor of claim 5, wherein the second layer of the double layer is on top of the first layer of the double layer.

7. The organic field effect transistor of claim 6, wherein the first layer of the double layer is on top of an adhesion layer.

8. A process for the preparation of the organic field effect transistor of claim 1 comprising the steps of
i) depositing a composition comprising single-walled carbon nanotubes having a content of at least 95% by weight of semiconducting single-walled carbon nanotubes in order to form a first layer comprising a percolating network of single-walled carbon nanotubes having a content of at least 95% by weight of semiconducting single-walled carbon nanotubes, and
ii) depositing a composition comprising organic semiconducting material in order to form a second layer comprising an organic semiconducting material.

## Patentansprüche

1. Organischer Feldeffekttransistor, umfassend eine Doppelschicht, bestehend aus
i) einer ersten Schicht, umfassend ein perkolierendes Netzwerk aus einwandigen Kohlenstoffnanoröhren mit einem Anteil von mindestens 95 Gew.-% halbleitenden einwandigen Kohlenstoffnanoröhren, und
ii) einer zweiten Schicht, umfassend ein organisches halbleitendes Material;
wobei die erste Schicht aus einem perkolierenden Netzwerk aus einwandigen Kohlenstoffnanoröhren besteht; und
wobei das organische halbleitende Material mindestens ein Material auf Diketopyrrolopyrrol-Basis ist, wobei das Material auf Diketopyrrolopyrrol-Basis ein Polymer auf Diketopyrrolopyrrol-Basis, bestehend aus Einheiten der Formel 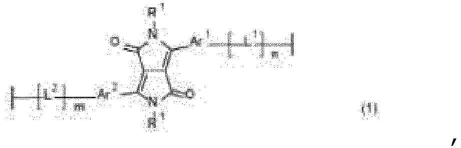 ist,
wobei
R¹ C₆₋₃₀-Alkyl ist,
n und m unabhängig voneinander 0 oder 1 sind, mit der Maßgabe, dass n und m nicht beide 0 sind, und
Ar¹ und Ar² unabhängig voneinander 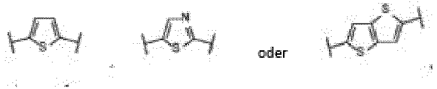 sind,
L¹ und L² unabhängig voneinander ausgewählt sind aus der Gruppe bestehend aus 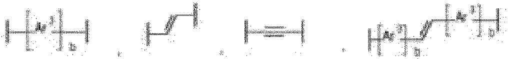 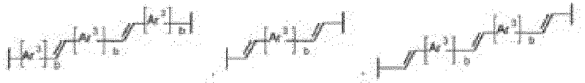 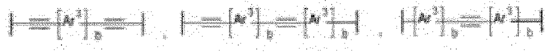 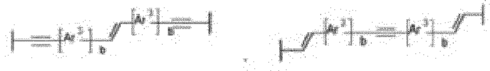 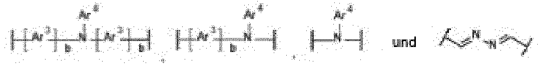
wobei
Ar³ bei jedem Vorkommen Arylen oder Heteroarylen ist, wobei Arylen und Heterorarylen substituiert sein können mit einem oder mehreren C₁₋₃₀-Alkyl, C₂₋₃₀-Alkenyl, C₂₋₃₀-Alkinyl, O-C₁₋₃₀-Alkyl, Aryl oder Heteroraryl, welches C₁₋₃₀-Alkyl, C₂₋₃₀-Alkenyl, C₂₋₃₀-Alkinyl, O-C₁₋₃₀-Alkyl, Aryl und Heteroaryl substituiert sein können mit einem oder mehreren C₁₋₂₀-Alkyl, O-C₁₋₂₀-Alkyl oder Phenyl; und wobei benachbarte Ar³ über einen Linker CR^{b}R^{b}, SiR^{b}R^{b} oder GeR^{b}R^{b} verbunden sein können, wobei R^{b} bei jedem Vorkommen H, C₁₋₃₀-Alkyl oder Aryl ist, welches C₁₋₃₀-Alkyl und Aryl substituiert sein können mit einem oder mehreren C₁₋₂₀-Alkyl, O-C₁₋₂₀-Alkyl oder Phenyl,
b bei jedem Vorkommen eine ganze Zahl von 1 bis 8 ist und Ar⁴ bei jedem Vorkommen Aryl oder Heteroaryl ist, wobei Aryl und Heteroraryl substituiert sein können mit einem oder mehreren C₁₋₃₀-Alkyl, O-C₁₋₃₀-Alkyl oder Phenyl, welches Phenyl substituiert sein kann mit C₁₋₂₀-Alkyl oder O-C₁₋₂₀-Alkyl.

2. Organischer Feldeffekttransistor nach Anspruch 1, wobei das perkolierende Netzwerk aus einwandigen Kohlenstoffnanoröhren einen Anteil von mindestens 99 Gew.-% halbleitenden einwandigen Kohlenstoffnanoröhren aufweist.

3. Organischer Feldeffekttransistor nach einem der Ansprüche 1 bis 2, wobei die einwandigen Kohlenstoffnanoröhren einen Durchmesser von 0,5 bis 3 nm und eine Länge im Bereich von 0,1 bis 100 µm aufweisen.

4. Organischer Feldeffekttransistor nach Anspruch 1, wobei das Material auf Diketopyrrolopyrrol-Basis ein Polymer auf Diketopyrrolopyrrol-Basis, bestehend aus Einheiten der Formel 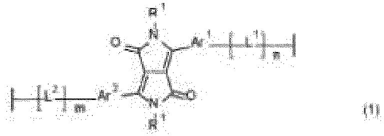 ist,
wobei
R1 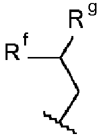 ist,
wobei
R^{f} C₆₋₁₄-Alkyl ist,
R^{g} C₂₋₁₂-Alkyl ist,
n und m unabhängig voneinander 0 oder 1 sind, mit der Maßgabe, dass n und m nicht beide 0 sind, und
Ar¹ und Ar² 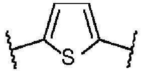 sind,
L¹ und L² unabhängig voneinander ausgewählt sind aus der Gruppe bestehend aus 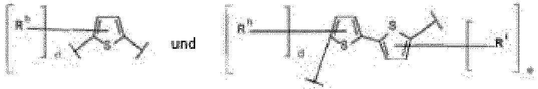
wobei
R^{h} und Rⁱ unabhängig voneinander C₆₋₃₀-Alkyl sind und
d und e unabhängig voneinander 0 oder 1 sind.

5. Organischer Feldeffekttransistor nach einem der Ansprüche 1 bis 4, wobei der organische Feldeffekttransistor ein organischer Feldeffekttransistor mit untenliegendem Gate ist.

6. Organischer Feldeffekttransistor nach Anspruch 5, wobei die zweite Schicht der Doppelschicht oben auf der ersten Schicht der Doppelschicht liegt.

7. Organischer Feldeffekttransistor nach Anspruch 6, wobei die erste Schicht der Doppelschicht oben auf einer Haftschicht liegt.

8. Verfahren zur Herstellung des organischen Feldeffekttransistors nach Anspruch 1, umfassend die folgenden Schritte:
i) Abscheiden einer Zusammensetzung, umfassend einwandige Kohlenstoffnanoröhren mit einem Anteil von mindestens 95 Gew.-% halbleitenden einwandigen Kohlenstoffnanoröhren, um eine erste Schicht, umfassend ein perkolierendes Netzwerk aus einwandigen Kohlenstoffnanoröhren mit einem Anteil von mindestens 95 Gew.-% halbleitenden einwandigen Kohlenstoffnanoröhren, zu bilden, und
ii) Abscheiden einer Zusammensetzung, umfassend organisches halbleitendes Material, um eine zweite Schicht, umfassend ein organisches halbleitendes Material, zu bilden.

## Revendications

1. Transistor à effet de champ organique comprenant une double couche constituée de
i) une première couche comprenant un réseau de percolation de nanotubes de carbone à simple paroi ayant une teneur d'au moins 95 % en poids de nanotubes de carbone à simple paroi semiconducteurs et
ii) une seconde couche comprenant un matériau semiconducteur organique ;
la première couche étant constituée d'un réseau de percolation de nanotubes de carbone à simple paroi ; et
le matériau semiconducteur organique étant au moins un matériau à base de dicétopyrrolepyrrole, le matériau à base de dicétopyrrolepyrrole étant un polymère à base de dicétopyrrolepyrrole constitué d'unités de formule 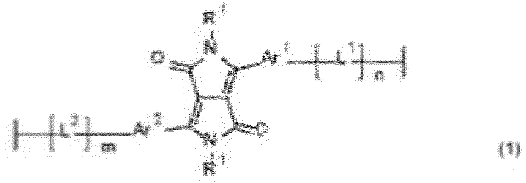 où
R¹ est un groupe alkyle en C₆ à C₃₀,
n et m valent indépendamment 0 ou 1, pourvu que n et m ne valent pas tous les deux 0, et
Ar¹ et Ar² sont indépendamment 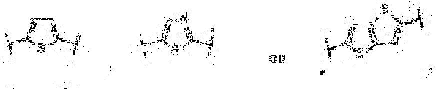
L¹ et L² sont indépendamment choisis dans le groupe constitué par 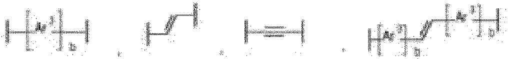 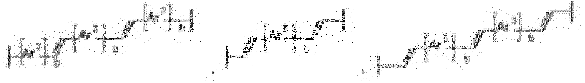 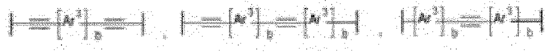 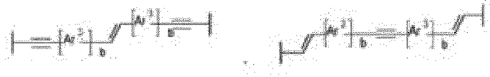 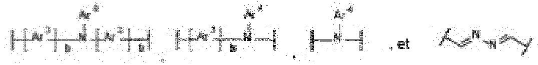 où
Ar³ est à chaque occurrence un groupe arylène ou hétéroarylène, les groupes arylène et hétéroarylène pouvant être substitués avec un ou plusieurs groupes alkyle en C₁ à C₃₀, alcényle en C₂ à C₃₀, alcynyle en C₂ à C₃₀, O-alkyle en C₁ à C₃₀, aryle ou hétéroaryle, lesquels groupes alkyle en C₁ à C₃₀, alcényle en C₂ à C₃₀, alcynyle en C₂ à C₃₀, O-alkyle en C₁ à C₃₀, aryle et hétéroaryle peuvent être substitués avec un ou plusieurs groupes alkyle en C₁ à C₂₀, O-alkyle en C₁ à C₂₀ ou phényle ; et les Ar³ adjacents peuvent être connectés via un lieur CR^{b}R^{b}, SiR^{b}R^{b} ou GeR^{b}R^{b}, R^{b} étant à chaque occurrence H, un groupe alkyle en C₁ à C₃₀ ou aryle, lesquels groupes alkyle en C₁ à C₃₀ et aryle peuvent être substitués avec un ou plusieurs groupes alkyle en C₁ à C₂₀, O-alkyle en C₁ à C₂₀ ou phényle,
b est à chaque occurrence un nombre entier de 1 à 8, et Ar⁴ est à chaque occurrence un groupe aryle ou hétéroaryle, les groupe aryle et hétéroaryle pouvant être substitués avec un ou plusieurs groupes alkyle en C₁ à C₃₀, O-alkyle en C₁ à C₃₀ ou phényle, lequel groupe phényle peut être substitué avec un groupe alkyle en C₁ à C₂₀ ou O-alkyle en C₁ à C₂₀.

2. Transistor à effet de champ selon la revendication 1, dans lequel le réseau de percolation de nanotubes de carbone à simple paroi a une teneur d'au moins 99 % en poids de nanotubes de carbone à simple paroi semiconducteurs.

3. Transistor à effet de champ organique selon l'une quelconque des revendications 1 ou 2, dans lequel les nanotubes de carbone à simple paroi ont un diamètre de 0,5 à 3 nm et une longueur dans la plage de 0,1 à 100 pm.

4. Transistor à effet de champ organique selon la revendication 1, dans lequel le matériau à base dedicétopyrrolepyrrole est un polymère à base dedicétopyrrolepyrrole constitué d'unités de formule 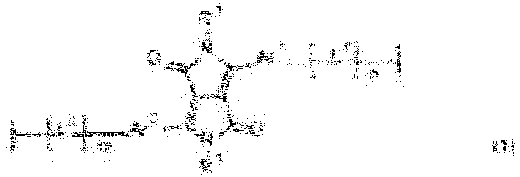 où
R¹ est 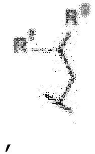 où
R^{f} est un groupe alkyle en C₆ à C₁₄,
R^{g} est un groupe alkyle en C₂ à C₁₂,
n et m valent indépendamment 0 ou 1, pourvu que n et m ne valent pas tous les deux 0 et Ar¹ et Ar² sont 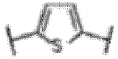
L¹ et L² sont indépendamment choisis dans le groupe constitué par 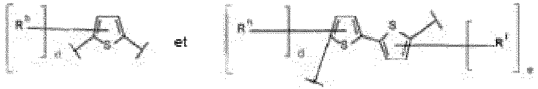
R^{h} et Rⁱ sont indépendamment un groupe alkyle en C₆ à C₃₀, et
d et e valent indépendamment 0 ou 1.

5. Transistor à effet de champ organique selon l'une quelconque des revendications 1 à 4, dans lequel le transistor à effet de champ organique est un transistor à effet de champ organique à porte de partie inférieure.

6. Transistor à effet de champ organique selon la revendication 5, dans lequel la seconde couche de la double couche est sur la partie supérieure de la première couche de la double couche.

7. Transistor à effet de champ organique selon la revendication 6, dans lequel la première couche de la double couche est sur la partie supérieure d'une couche d'adhésion.

8. Procédé de préparation du transistor à effet de champ organique selon la revendication 1 comprenant les étapes consistant à
i) déposer une composition comprenant des nanotubes de carbone à simple paroi ayant une teneur d'au moins 95 % en poids de nanotubes de carbone à simple paroi semiconducteurs pour former une première couche comprenant un réseau de percolation de nanotubes de carbone à simple paroi ayant une teneur d'au moins 95 % en poids de nanotubes de carbone à simple paroi semiconducteurs et
ii) déposer une composition comprenant un matériau semiconducteur organique pour former une seconde couche comprenant un matériau semiconducteur organique.
